# EUROPEAN PATENT APPLICATION

(11) **EP 2 704 186 A1**
(43) Date of publication of application: **05.03.2014**
(21) Application number: 12181904.9
(22) Date of filing: 27.08.2012
(51) Int. Cl.: H01L 21/607, G06K 19/077, B23K 20/00

(54) **Method for laying a wire conductor onto a substrate and for connecting it to a chip**

(71) Applicant: Finlay, Garreth, Ballymote, Co. Sligo (IE); Hynes, Fergus, Strandhill, Co. Sligo (IE)
(72) Inventor: Finlay, Garreth, Ballymote, Co. Sligo (IE); Hynes, Fergus, Strandhill, Co. Sligo (IE)
(74) Representative: Misselhorn, Hein-Martin

(57) **Abstract**

Method for laying a wire conductor (3) on a card substrate by means of a wire laying pin (10), which embeds the wire conductor (3) under the influence of ultrasound into the surface of the card substrate, and for the electrically conductive connection of the wire conductor (3) to a contact surface of a RFID chip (4), which is attached to the card substrate, by means of a welding die (11), wherein the wire laying pin (10), subsequent to an attachment of the wire conductor (3) to the card substrate, is lifted off the card substrate and then moved into a position starting from which the wire conductor (3) forms a straight wire line extending in the air space above the card substrate and extending from the mouth of the wire laying pin (10) to an attachment point at which the wire conductor (3) is attached to the card substrate or embedded into the card substrate, whereupon the welding die (11) grips the wire (3) in the area between the wire laying pin (10) and the end point of the wire laying cycle, brings it up to the contact surface of the RFID chip (4) associated therewith, and welds it to the contact surface or whereupon a wire gripper (18) grips the wire conductor (3) in the area between the wire laying pin (10) and the attachment point, the wire gripper (18) and preferably also the wire laying pin (10) are then moved in such a way that the wire conductor (3) spanned in between them from now on traverses the contact surface of the RFID chip (4) associated therewith, finally the welding die (11) presses the wire conductor (3) spanned in between the wire gripper (11) and the wire laying pin (10) onto the contact surface and welds it to the contact surface.

## Description

The invention relates to a method for laying a wire conductor on a card substrate and for contacting the wire conductor to a chip attached to the substrate. The invention moreover relates to a device for carrying out such a method.

Typically, RFID cards are produced by means of such a method and such a device. In the case of cards of this type, a chip is attached to the card substrate. Then, the front end of a wire conductor is connected in an electrically conductive manner to the first contact surface of the chip. Subsequently, the wire conductor is laid on the surface so as to form a coil. Once this has been done, the tail end of the wire conductor is connected to a second contact surface of the chip.

A generic method is known from the European patent EP 0 880 754. This patent describes the following procedure:
In order to lay the wire conductor on the card substrate, a wire laying pin is used which guides the wire conductor in relation to the substrate. The wire conductor is embedded into the surface of the card substrate by means of an ultrasound vibration device which applies ultrasound vibrations to the wire laying pin that act perpendicularly to the substrate surface of the card substrate and which embed the wire conductor in the card substrate.

The difficulty in such a process lies in properly connecting the wire conductor to the terminal areas of the chip. This is difficult because the wire conductors used are very fine, and the chips highly miniaturized, so that they only have correspondingly small contact surfaces.

The known patent proposes to solve this problem by the chip first being mounted on the substrate. Then, the wire is embedded into the surface of the substrate on the one side of the chip and brought up to the chip in this manner. Now, the process of embedding the wire conductor is interrupted and the wire conductor is guided over the chip so as to come to rest on the terminal area of the chip. Starting from the point at which the chip has crossed the wire conductor, it is again embedded into the substrate at least locally. In this way, the wire conductor is fixed relative to the chip in such a manner that it already assumes its correct position on the contact surface of the chip and is incapable of being removed from this position. In order to produce a reliable electrically conductive connection between the wire conductor and the contact surface of the chip, a welding die now only has to be pressed onto the already properly positioned wire conductor. This can then weld the wire conductor to the contact surface by means of ultrasound vibrations without measures having to be taken at this stage to ensure the correct positioning of the wire conductor.

The procedure can be used both for connecting in an electrically conductive manner the front end of the wire conductor to the contact surface of the chip as well as connecting in an electrically conductive manner the tail end of the wire conductor, subsequent to it being laid as a coil, to the second contact surface of the chip.

If the chip is to be mounted onto the substrate not right away, but only after laying the wire conductor as a coil, the known patent makes an alternative proposal. In that case, a window is to be punched into the substrate. The chip is later inserted in to the window with an exact fit. The front end and the tail end of the wire are to be drawn over this window in such a way that both the front end as well as the tail end of the respective wire conductor are attached to the substrate on both sides of the window. In this way, the wire conductor is fixed to the substrate in such a manner, both at its front end as well as at its tail end, that, later, when the chip is inserted into the window, it comes to lie correctly on the contact surfaces of the chip without any problems. Also in this case, the welding die only has to be pressed onto the wire conductor in order to weld it to the contact surfaces. It does not have to be ensured anymore that the wire really is properly positioned, for it is attached to the substrate in the exact position.

The above-described method is disadvantageous in that it is relatively time-consuming. This is the case because the wire conductor has to be connected to the substrate on both sides of the chip or of the window provided for accommodating the chip, in order to provide the conditions for contacting.

It is the object of the invention to propose a more efficient method and a corresponding device for carrying out this method.

According to the invention, it is no longer necessary to embed the wire conductor into the substrate on both sides of the chip or to attach it to the substrate.

Instead, the procedure is that the wire laying pin is lifted off the substrate at the end of the wire laying cycle and then moved into a position from which the wire forms a wire line that extends in the air space above the substrate, is continuously straight or at least substantially straight. This straight wire line, which corresponds to that area of the wire conductor that is to be connected to the chip, is at that stage not fixed to the substrate - neither relative to the contact surface of the chip, nor relative to an area accommodating the contact surface of the chip. Instead, its position relative to the contact surface of the chip is determined by the wire laying pin.

The section of the wire conductor which extends at least substantially, preferably completely, in a straight line between the wire laying pin and an attachment point F can be easily gripped by the welding die and pressed against the contact surface of the chip. Then, the welding die welds the wire conductor to the chip. This is a first alternative of the invention.

The section of the wire conductor that extends at least substantially, preferably completely, in a straight line between the wire laying pin and an attachment point F can be easily gripped by a wire gripper (12). Then, at least the wire gripper (12) is moved into a position in which the part of the wire conductor spanned in between the wire gripper (12) and the wire laying pin (10) from now on traverses the contact surface (7, 8) of the chip (4) associated therewith. Now the welding die (11) is activated so that it comes into contact with the wire conductor in the area above the contact surface (7, 8) and presses it down onto the contact surface. There the wire conductor is welded to the contact surface. This is a second alternative of the invention.

Both alternatives of the inventive method are used primarily in order to connect the tail end of the wire conductor that is at first free after the laying of the coil has been completed to the contact surface of the chip.

However, it may also used in a corresponding manner in order to connect the front end of the wire conductor to the contact surface of the chip and to start laying the wire conductor on the substrate as a coil thereafter. For this purpose, the wire conductor is then (preferably) connected to the substrate at at least one location, so that an attachment point F is available, starting from which the wire conductor can form a straight wire line between this attachment point and the wire laying pin, which preferably extends in the air space above the chip.

A preferred embodiment provides that the wire conductor, at the beginning of a wire laying cycle and/or at the end of a wire laying cycle, is held between the wire laying pin and a wire gripper spaced apart therefrom, in such a way that the wire conductor forms a continuously straight wire line extending in the air space above the substrate and extending from the mouth of the wire laying pin to the wire gripper, whereupon the welding die grips the wire conductor in the area between the wire laying pin and the wire gripper, brings it up to the contact surface of the chip associated therewith, and welds it to the contact surface. That facilitates the connection due to the fact, that the position of the straight wire line is strictly defined through the position of the wire laying pin and the wire gripper.

Preferably the chip is attached to the substrate only after the wire conductor has been welded to the contact surface of the chip.

It is advantageous that the wire laying pin releases the wire conductor, preferably before the welding die impacts the wire conductor, in such a way that the welding die is able to draw at least that additional length of the wire conductor from the wire laying pin that is required in order to prevent the wire conductor from breaking due to the influence of the welding die.

Another preferred embodiment provides that, during the phase in which the welding die brings the wire conductor up to the contact surface or in which the welding die presses the wire conductor onto the contact surface, the wire laying pin feeds by means of its active wire feed at least that additional length of the wire conductor that is required in order to prevent the wire conductor from breaking due to the influence of the welding die.

Preferably the wire laying pin is moved into a position that is so far distant from the attachment point (F) or the wire gripper that the length of the wire conductor forming a line between the mouth of the wire laying pin and the attachment point or the wire gripper is so great that the wire conductor is resilient to such an extent that, by means of the welding die, it can be brought up to the contact surface and/or it can be pressed onto the contact surface of the chip associated with it and welded to the contact surface without breaking.

A very preferred method is characterized in that the wire laying pin is a passive element and the vibration between the wire laying pin and the substrate required for embedding the wire conductor into the substrate is applied by a vibrating die which presses through the substrate against the wire laying pin from the side of the substrate facing away from the wire laying pin. Independent protection for an apparatus performing such a process is claimed, too.

Another problem to whose solution the invention is dedicated is the preparation of the ends of the wire laid in the form of a coil in order to be able to then produce an electrically conductive connection between the wire and the chip.

A lot of effort is required to grip the free ends of the wire and to decoat or clean them in order to optionally tin-plate them subsequently thereto, and to thus prepare them for connection to the terminal areas of the chip by soldering or bonding.

Accordingly, it is the object of the invention to specify a method which permits a more efficient cleaning and optionally tin-plating of those areas of the wire that form the free ends of the wire laid in the form of a coil.

In order to achieve this object, the invention proposes that the wire, prior to it being fed into the wire guide, be stripped or decoated and/or cleaned and/or tin-plated and/or coated with a conductive adhesive or contacting agent in an area which later forms one tail end of one and a front end of a second coil;

Preferably, at least such an amount of wire is always pulled from the wire supply in the process that a free continuous wire is spanned between the mouth section of the wire laying pin and the wire supply with a length which corresponds to at least the wire length required for the production of the next coil (hereinafter referred to as: free wire length). In the process, it is calculated in advance which area of the free wire corresponds to the area of the wire in which the wire is later connected to the contact surfaces of a first and a second RFID chip, whereupon this area is pretreated in a manner which later facilitates the electrically conductive connection to the contact surface, preferably by removal of the insulation of the wire in this area and/or tin-plating of the wire in this area, with the wire being fed to the wire laying pin and dispensed via its mouth section (opening) after the completion of the pretreatment;

Preferably a solder jet is used for tin plating in the form of a tube whose mouth is formed, preferably concavely, in such a way that the molten solder, which has preferably been fed against gravity through the inside of the tube, forms a sphere of liquid solder by utilizing the surface tension of the liquid solder, into which sphere the wire to be tin-plated can be immersed or through which it can be pulled and tin-plated in the process.

A preferred embodiment provides that the solder jet is configured and heated in such a way that the wire can be pulled through the solder jet in the feeding direction and is continuously stripped, cleaned and/or tin-plated in the process.

Independent from other claims protection is claimed for an apparatus for laying a wire conductor on a substrate by means of a wire laying pin, which embeds the wire conductor under the influence of ultrasound into the surface of the substrate, and for the electrically conductive connection of the wire conductor to a contact surface of a chip, which is attached to the substrate, by means of a soldering or welding die, characterized in that the apparatus is set up for performing a method according to what has been disclosed before.

Further advantages, optional embodiments and mechanisms of action of the invention become apparent from the description of the exemplary embodiments of the invention which is given with reference to the Figures. In the Figures:
Figure 1 shows, with reference to a first exemplary embodiment of the invention, how the front end of the wire conductor is attached to the contact surface of the chip prior to laying the wire conductor as a coil,
Figure 2 shows how, in the context of the first exemplary embodiment, the wire conductor is laid on the substrate,
Figure 3 shows a finished RFID chip according to the first exemplary embodiment,
Figure 4 shows how the tail end of the wire conductor is contacted to the chip,
Figure 5 shows a second exemplary embodiment which largely corresponds to the first exemplary embodiment, in which the process of laying the wire conductor on the substrate is different.
Figure 6 shows a wire guiding runner for guiding the wire over the contact surface of the chip.
Figure 7 shows the aforementioned wire guiding runner in greater detail.
Figure 8 illustrates a second embodiment of the method according to the invention, i.e. the first step thereof, in which the wire is pulled over the central area of the chip.
Figure 9 shows the second step of the exemplary embodiment shown by Figure 8, in which the wire has been gripped by the wire gripper 12 and is now held between the wire gripper 12 and the wire laying pin 10 and brought over the terminal area by these two together.
Figure 10 schematically shows the principle of the external stripping/cleaning/tin-plating of the wire even before it reaches the wire laying pin 10.
Figures 11 and 12 show details relating to the design of the solder jet used for the exemplary embodiment according to Figure 10.

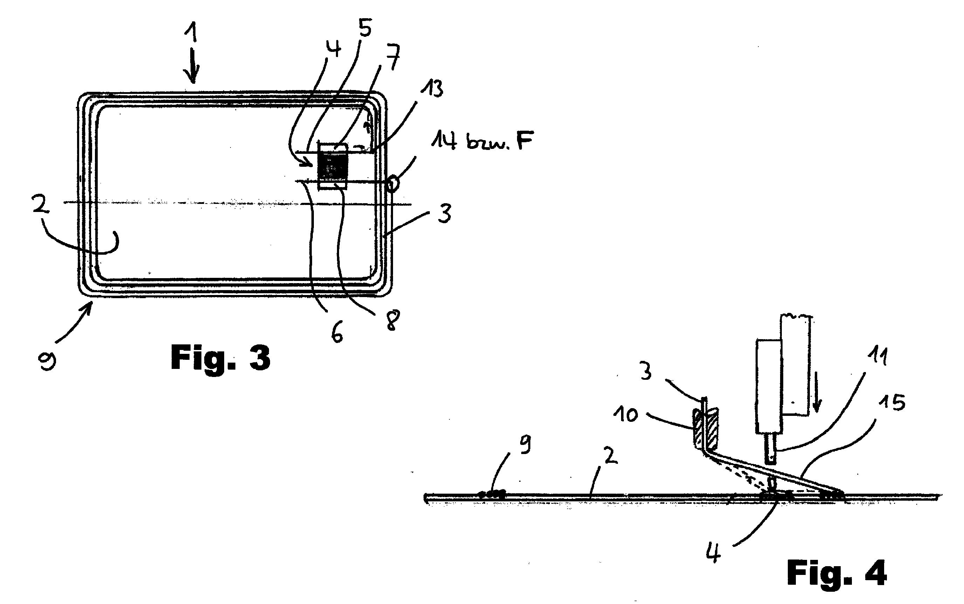

Figure 3 shows a complete view of an RFID card 1 as it is produced with the method according to the invention or a corresponding device.

As can be seen, a card substrate 2 is provided to which a chip 4 is attached. A wire conductor 3 is laid on the card substrate 2. The former there forms a coil 9 that serves as an antenna. The wire conductor 3 has a front end 5 that is connected in an electrically conductive manner to the first contact surface 7 of a chip. Reference numeral 13 marks the starting point of the wire laying cycle. From this point on, the wire conductor is embedded into the card substrate 2. Reference numeral 14 marks the end point of the wire laying cycle. The wire conductor is embedded into the card substrate 2 up to this point. The wire conductor has an end 6 that is connected in an electrically conductive manner to the second contact surface 8 of a chip 4.

How the wire conductor 3 is embedded into the card substrate or into an adhesive layer applied to the surface of the card substrate is known. In this respect, reference is made to the "Handbuch der Leiterplattentechnik" by Herrmann / Egerer published by Leuze-Verlag.

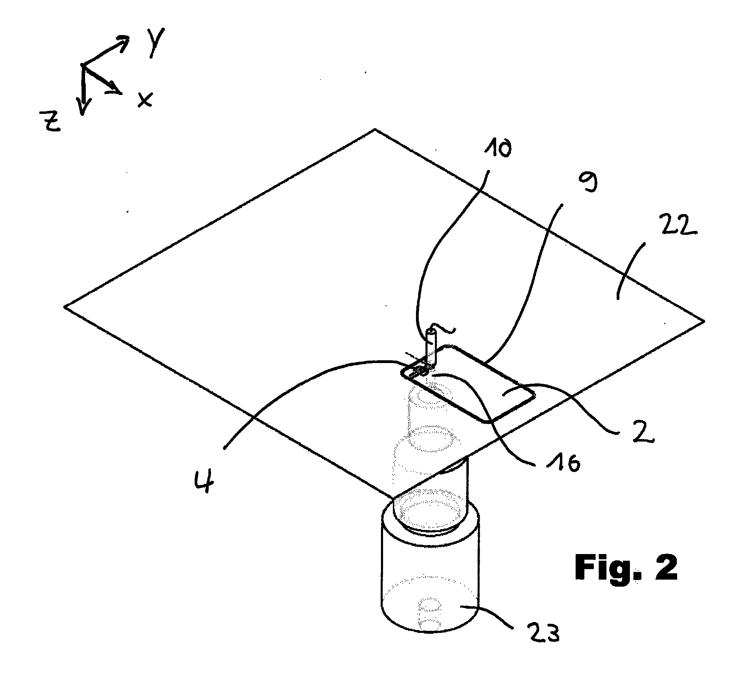

A special feature of the method according to the invention, or of the machine for carrying out this method, lies in the fact that the vibrating die 16 (see Fig. 2), which produces the vibrations required for embedding the wire conductor 3 into the substrate surface, is not disposed on the same side of the substrate as the wire laying pin 10. It is thus possible to use a very narrow wire laying pin 10. The construction space otherwise required above the actual wire laying pin 10 for the oscillator which, in accordance with the teaching of the prior art, applies the required ultrasound vibrations to the wire laying pin, can be used for other purposes.

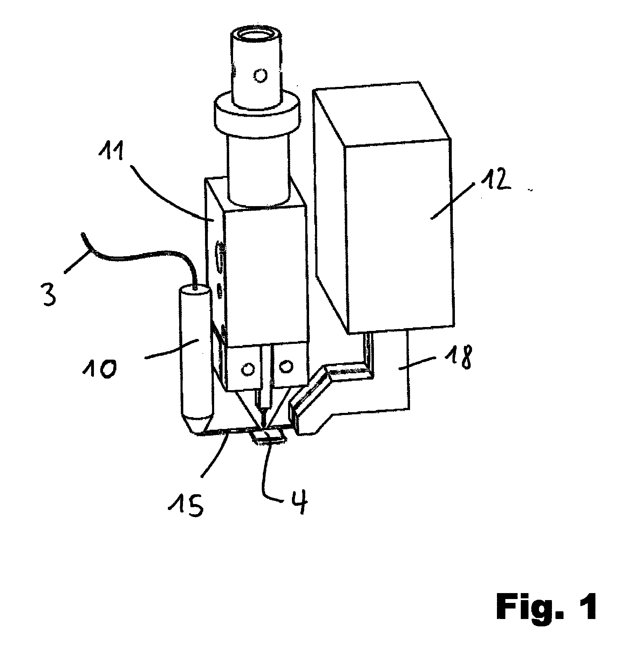

This makes it possible to provide an arrangement consisting of a wire laying pin 10, a welding die 11 and a wire gripper 12, as Figure 1 shows. The arrangement is characterized in that the wire laying pin 10, the welding die 11 and the wire gripper 12 can be positioned very closely next to one another. The distance between the wire laying pin 10 and the location at which the wire conductor comes into contact with the wire gripper 12 is reduced even more by the fact that the wire gripper 12 is preferably formed as tongs 18 that are bent towards the side, in the direction parallel to the substrate surface, which grip the wire conductor.

Such an arrangement makes it possible to connect the front end 5 of the wire conductor to the first contact surface 7 of the chip associated with it quicker than would be possible if the wire conductor would first have to be attached to the substrate followed by a subsequent welding operation.

For this purpose, the process is as follows:
The chip is either held in a defined position outside of the substrate 2, for example by means of a suction gripper. Alternatively, it is first attached to the substrate 2 in a defined position. Then, the front end of the wire conductor 3 that at first freely protrudes from the wire laying pin 10 is gripped and held by the preferably bent tongs 18 of the wire gripper 12. Now, the wire laying pin 10 and/or the wire gripper 12 are moved in such a way that the wire forms a straight wire line 15 between these two organs that extends through the air space above the chip 4, preferably in such a way that the projection of the wire line into the plane of the substrate surface forms a line intersecting the contact surface of the chip. Said straight line 15 is not fixed to the substrate at this point in time, but is held in position solely by the wire laying pin 10 and the wire gripper 12.

The position of the straight wire line 15 is known at least substantially; it can be computed from the position of the wire laying pin 10 the position of the wire gripper 12 and adjusted through a corresponding movement of the wire laying pin 10 and/or the wire gripper 12.

Therefore, there is no difficulty in moving the welding die 11 towards the straight wire line 15 in such a way that the welding die 11 encounters the straight wire line 15 and then guides the wire conductor against the corresponding contact surface of the chip and presses it against that. Once this has happened, the wire conductor can be welded to the contact surface of the chip by the welding die so that a reliable electrical connection is established.

After this has happened, the wire laying pin 10 is moved to the starting point 13 of the wire laying cycle. There, the wire laying pin 10 is lowered onto the substrate and embeds the wire conductor by means of ultrasound vibrations into the surface of the card substrate or an adhesive layer applied thereto. In the process, the feed is carried out in such a way that the wire conductor 3 forms the coil 9 shown by Figure 3.

The laying of the wire is continued until the end point 14 of the wire laying cycle. Once the end point 14 of the wire laying cycle has been reached, the wire laying pin 10 is lifted off the card substrate 2.

According to a first alternative of the invention the end of the wire conductor forming the coil is brought into electrically conductive contact as explained hereinafter with reference to Fig. 3:
The wire laying pin 10 is now moved over the chip 4 into a position starting from which the wire forms an at least substantially continuously straight wire line 15 extending in the air space above the substrate, see Fig. 4. This wire line 15 extends from the mouth of the wire laying pin 10 to the end point 14 of the wire laying cycle at which the wire was last embedded into the substrate, which forms the so-called attachment point F.

Now, the welding die 11 is moved towards the wire line 15. The welding die 11 captures the wire in the area of the wire line 15, guides it towards the second contact surface 8 of the chip 4 associated with it and presses it against that. Then, the welding die 11 welds the wire conductor to the contact surface 8.

It should be remarked that the welding die 11 can be configured in different ways. In the simplest case, the welding die 11 ends in a simple bolt-shaped section with which it is only capable of pressing against the wire conductor 3 forming the wire line 15, without exerting a lateral guiding action on it.

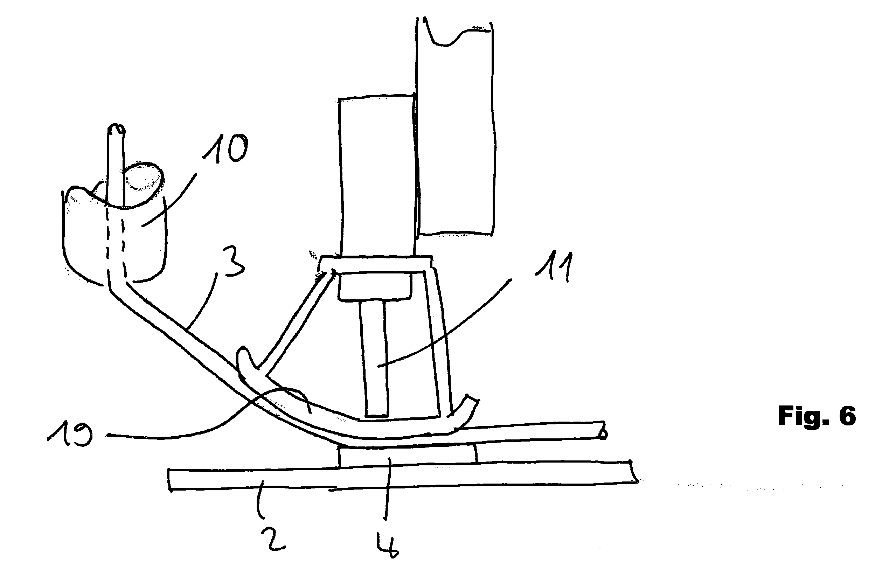

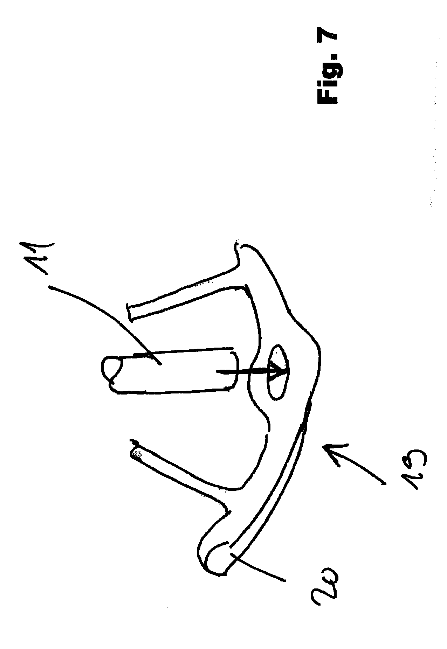

However, a special development of the invention provides that the welding die is provided with a guiding runner 19 into which the wire conductor inserts itself when the welding die is moved towards the wire line 15. The guide runner 19 is provided with a groove or notch that is capable of guiding the wire in the lateral direction, i.e. parallel to the substrate surface, once the wire of the wire line 15 has inserted itself in it. Figures 6 and 7 illustrate what is meant by this. The use of such a wire guiding runner 19 does away with the requirement of positioning the wire line 15 in exactly such a manner that it extends in the air space above the contact surface. Instead, the wire guiding runner 19 makes it possible to adjust the exact position of the wire by means of the welding die.

Figure 6 shows the details of the wire guiding runner 19. Here, the card substrate 2 to which the chip 4 is attached can be seen rather well. The welding die 11 can also be seen well. The wire guiding runner 19 is attached to the device which carries the welding die 11 and which is not defined in more detail. Here, the wire guiding runner 16 has an approximately C-shaped design and comprises a central groove or notch into which the wire conductor 3 inserts itself once the wire guiding runner 19 is moved against the wire conductor 3. In this way, the wire conductor 3 can be entrained and lowered by the wire guiding runner not only in the direction perpendicular to the substrate surface, but can also be entrained in the lateral direction until it comes to rest, exactly in position, on the contact surface of the chip 4 associated with it. Once the wire guiding runner 19 has abutted the wire conductor 3 against the contact surface, the welding die 11 is pressed against the wire conductor 3 through a corresponding cut-out of the wire guiding runner 19. Preferably, the wire guiding runner is now lifted so that only the welding die 11 still presses against the wire conductor. This prevents the wire conductor 3 from being welded or glued to the wire guiding runner 19 under unfavorable circumstances. The welding die now begins executing a movement oscillating parallel to the substrate surface, whereby the wire conductor 3 is welded to the contact surface of the chip.

Figure 7 is able to give a more detailed picture of the wire guiding runner 19. A rough outline of the wire guiding runner 19 can be seen here. The wire guiding groove 20 can be seen here that the wire guiding runner 19 comprises and with which the wire guiding runner 19 is capable of guiding the wire conductor 3 also laterally, in order to thus adjust the exact position of the wire conductor 3 so that it encounters the contact surface exactly. One can also see the central passage 21 of the wire guiding runner 19 provided for letting the welding die 11 through, so that the wire guiding runner 19 can be lifted off the wire conductor 3 once the welding die 11 presses the wire conductor 3 securely against the contact surface on the chip.

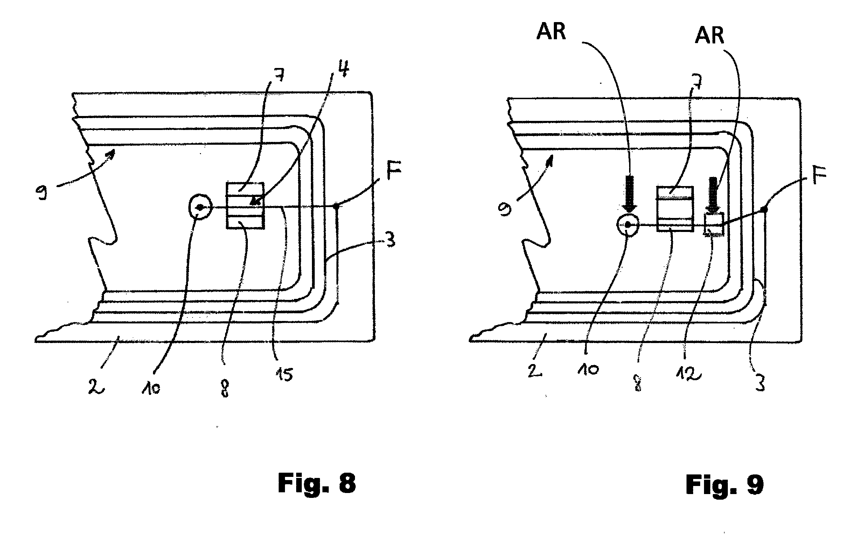

According to a second alternative of the invention the end of the wire conductor forming the coil is brought into electrically conductive contact as explained hereinafter with reference to Figs. 8 and 9:
The wire laying pin 10 is now moved over the chip 4 into a position starting from which the wire forms an at least substantially continuously straight wire line 15 extending in the air space above the substrate in such a way that the straight wire line 15 does not traverse or not fully traverse the second contact surface 8, see Fig. 8. This wire line 15 extends from the mouth of the wire laying pin 10 to the end point 14 of the wire laying cycle at which the wire was last embedded into the substrate, which forms the so-called attachment point F.

Now a wire gripper 12 is moved towards the wire line 15 and captures the wire in the area of the wire line 15 at a point between the wire laying pin and the wire attachment point F. Such a gripping action does not constitute any problem at all because the position of the straight wire line 15 is known at least substantially. As already mentioned it can be computed from the position of the wire laying pin 10 and the (stored) position of the wire attachment point, i. e. the position that has been assumed by the wire laying pin 10 when lifting it off from the card substrate 2.

After having been captured by the wire gripper the wire conductor forms a straight wire line between the wire laying pin and the wire gripper 12.

As illustrated by Figure 9 the wire laying pin 10 and the wire gripper 12 are moved in the direction of the arrows AR. Preferably the wire laying pin 10 and the wire gripper 12 are moved synchronously. The wire laying pin 10 and the gripper 12 are stopped in a position where the straight wire line in between them traverses the second contact surface.

Now, the welding die 11 is moved towards the wire line 15. The welding die 11 captures the wire in the area of the wire line 15 (preferably without executing a special guiding action in lateral direction), and presses it onto the second contact surface 8. Then, the welding die 11 welds the wire conductor to the contact surface 8.

When one of the methods according to the invention is executed, it must be ensured that the welding die 11 does not break the wire conductor 3 when it captures it and brings it up to the contact surface of the chip unit. In order to accomplish this, the wire conductor can (optionally) be released, on the side of the wire laying pin, in such a way that the welding die is able to draw at least that additional length of the wire conductor from the wire laying pin that is required in order to prevent the wire conductor from breaking due to the influence of the welding die. It is even more beneficial if the feeding device that pushes the wire through the mouth of the wire laying pin 10 is controlled in such a way that an additional length of the wire conductor is actively fed via the wire laying pin. In this case, the feeding speed is set so as to match the feed of the welding die 11. An alternative not depicted by a figure is that wire tension is maintained with a dancer arm or similar to allow the additional wire length to be drawn. By one or more of the aforementioned tension control means the wire conductor 3 is prevented from relaxing to such an extent that it assumes a position which is not exactly predetermined anymore and then slips off the welding die 11.

How the actual laying of the wire on the substrate takes place is illustrated by Figure 2. This method of laying the wire is useful for both of the alternative methods for "marrying" the wire conductor to the contact surface associated with it. Figure 2 shows a panel 22 on which a plurality of card substrates 2 is formed, of which, however, only one is shown here. The wire laying pin 10 - at least in some sections - is configured as a tube that is hollow inside, through whose hollow interior the wire conductor 3 is fed from a supply. The wire conductor 3 leaves the hollow interior of the wire laying pin 10 at the end face thereof facing towards the card substrate 2, also see Fig. 1. The wire laying pin is mounted in such a way that it can be advanced in the Z-direction and moved in the X- and Y-direction of the Cartesian coordinate system shown, parallel to the surface of the panel or the card substrate 2. The wire laying pin 10 is in this case brought from a first side of the card substrate 2 down to its surface.

From a second side of the card substrate 2, a vibrating die 16 is brought closer to which an ultrasonic generator 23 applies ultrasound vibrations which induce movements perpendicular to the surface of the card substrate 2. The vibrating die 16 presses from below via the card substrate 2 against the end face of the wire laying pin 10. It transmits its ultrasound vibrations through the card substrate 2 onto the wire laying pin 10, or on the wire conductor 3 protruding from the wire laying pin 10. The vibrating die 16 can also be advanced in the Z-direction and moved in the X- and Y-direction. The wire laying pin 10 and the vibrating die 16 are synchronously moved along the surface of the card substrate 2 while maintaining a constant force between without the pressing action that the wire laying pin 10 and the vibrating die 16 exert on each other being canceled. In this manner, the wire is embedded into the surface of the substrate. At the end point 14 of the wire laying cycle, the wire laying pin 10 and the vibrating die 16 are lifted off the surface of the substrate.

Figure 2 presents a rather illustrative example of why the wire laying pin 10 is a passive element, according to the invention, which itself does not generate any ultrasound. As can be seen, the ultrasonic generator 23 requires a very considerable amount of construction space in the vicinity of the surface of the card substrate 2. It is therefore impossible, on the side on which the ultrasonic generator 23 is accommodated, to move the wire laying pin 10 and the welding die 11, and optionally the wire gripper 12, as close together as is shown by Figure 1, or by Fig. 4 with regard to the wire laying pin 10 and the welding die 11.

For the sake of completeness, it should be remarked that moving the wire laying pin 10 and the vibrating die 16 together in the X- and Y-axis direction is not an absolute requirement. Instead, it can also be so that the wire laying pin 10 and the vibrating die 16 are stationarily mounted and the panel 22 or the card substrate 2 are moved back and forth in the X- and Y-axis direction, so that the wire conductor 3 is embedded as a coil into the surface of the card substrate 2 in this manner.

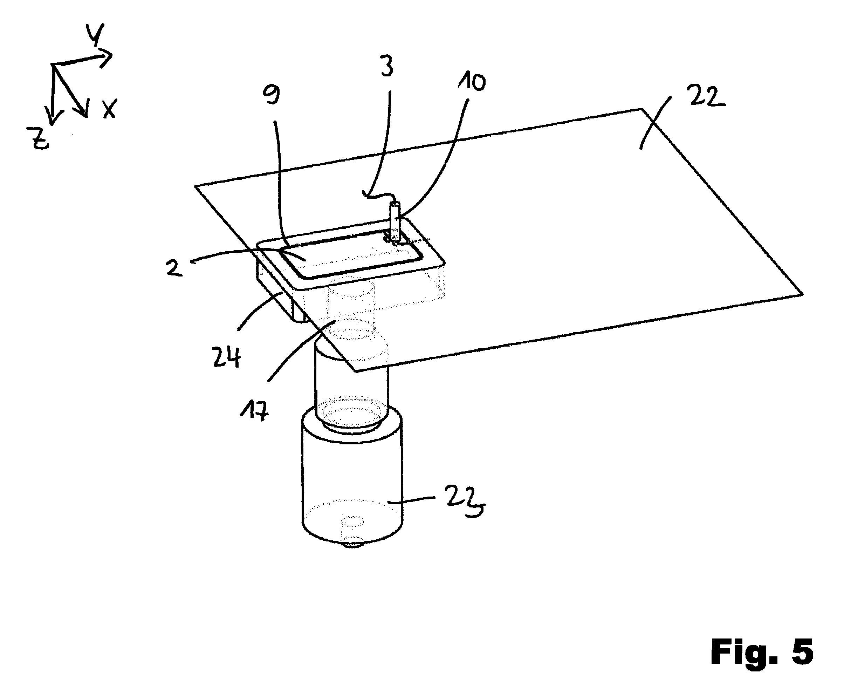

An alternative method for applying the ultrasound vibrations required for embedding the wire conductor into the card substrate is shown by Figure 5. This method in principle corresponds to the method according to the invention, the sole difference being that a vibrating die 17 of a different design is used. In this case, the vibrating die 17 transitions into a plate 24 whose surface area is larger than the surface area enclosed by the coil to be produced by embedding the wire conductor 3. Preferably, the surface area of the plate is substantially as large as the large surface of the card substrate.

The plate as a whole oscillates back and forth in a direction perpendicular to the substrate surface. It is excited to do so by a corresponding ultrasonic generator 23. The ultrasonic generator and the plate are either completely stationary, or stationary at least in the X- and Y-coordinate direction. The wire laying pin, which is again passive, can be advanced in the Z-direction and moved along the surface of the card substrate 2 in the X- and Y-direction; therefore, the effort for positionally exactly moving the plate can be dispensed with. The card substrate is exposed to a defined pressing action between the wire laying pin 10 and the plate.

The wire conductor 3 is embedded into the surface of the card substrate 2 so as to form a coil 9 by moving the wire laying pin 10 in a corresponding manner in the X- and Y-direction. Also in this case, the contacting of the front end and the tail end of the wire conductor to the corresponding contact surfaces of the chip takes place in the same way as was described above.

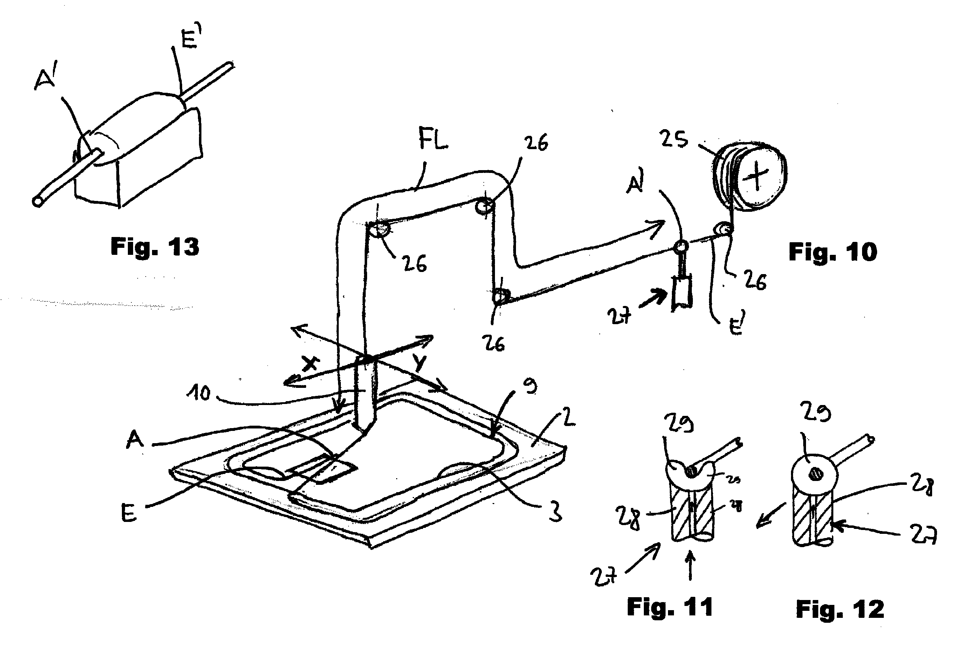

Figure 10 illustrates the manner according to the invention of cleaning and/or tin-plating the wire and thus preparing it for soldering or bonding it to the contact surfaces of the chip. In a laying method of the type discussed here, the wire laying pin 10 that can be advanced in the Z-direction and moved in the X/Y-direction in the substrate plane is fed with wire that is pulled off a wire supply 25, preferably in the form of a coil.

Fig. 10 shows an image of the moment in which the wire laying pin has just finished laying a coil on the substrate and has pulled the wire forming the second end of the coil across the chip. A wire is located between the mouth section of the wire laying pin 10 and the solder bath, which is in this case configured as a solder jet 27, with a free wire length FL, which at least substantially corresponds to the wire length that is required for producing the subsequent coil. In the situation shown by Fig. 10, the solder jet begins acting on the wire at a point A', which in the next coil, which is yet to be laid, corresponds to the point A on the coil of the wire already laid, i.e. to a point which is located preferably up to 20 mm before the contact surface of the chip. Then, the wire feed is switched on and the wire is pulled through the solder bath for such a period of time and at such a (mostly reduced) speed until that point E' on the wire has been reached which in the coil that is yet to be laid corresponds to the point E on the wire of the coil already laid. Alternatively, the solder jet can also be moved along the stationary wire. Ideally, the position of the points A' and E' is predetermined with such accuracy that the distance between the points A' and E' is so small that the entire section between these two points can be stripped or tin-plated simply by immersing the stationary wire into the stationary solder jet.

In every one of the aforementioned cases, the wire is stripped, cleaned and optionally tin-plated over the entire distance between the points A' and E'. Once this has happened, the solder jet 27 is retracted and the wire, including the section that has been pretreated as described above, is dispensed via the wire laying pin. What is important is that the distance between the points A' and E' and the absolute position of these points is always calculated in advance in such a way that a first part of the pretreated length (A'E') of the wire later becomes a part of a first coil or a first RFID unit, and a second part of the pretreated length (A'E') of the wire later comes a part of a second coil to be laid subsequent to the first coil. Thus, the division of the wire respectively takes place in the area of the wire length determined by A'E'.

By means of this process, for which protection is sought also, but not only, separately without reference to other parts of the invention, the stripping or decoating of the wire or the cleaning and/or tin-plating of the wire is spatially transferred to a location which is far distant from the location at which the wire ends currently have to be connected to the chip. This is a decisive advantage already because the devices required for stdpping/cleaning/tin-plating do not have to be accommodated and operated together with the wire laying pin and the wire gripper in a very confined space.

Figs. 11 and 12 depict the solder jet that is preferably to be used for this method.

Fig. 11 shows an image of the moment in which the solder jet 27, which is formed from an internally fed tube 28 that is preferably shaped in a concave manner at its free end, has just been advanced against the wire in the direction transverse to its longitudinal axis. A little sphere of liquid solder is held at the end of the tube 29 - liquid solder has a high surface tension and therefore does not run. The wire is immersed into this little sphere at this moment. As long as it has not reached the sufficient temperature yet, it cannot be wetted with the solder and therefore pushes the solder sphere back slightly. Once the wire has reached a sufficiently high temperature, the solder wets it as is shown in Fig. 12. If a longer section of wire is to be treated, the wire can now be pushed through the solder sphere and is continuously tin-plated in the process. Another alternate is to use a long rectangular jet, i.e. A-E in length, and just bring it up onto the wire and not move the jet, this will be quicker and simpler, see Fig. 13.

It should be noted that protection is separately also sought for the method described above and shown by the Figures 10, 11 and 12, independently from what is recorded in the other claims to which the claims refer that relate to this method. For this manner of preparing the wires for connection with the RFID chip by bonding or soldering can also be usefully employed in other methods for producing RFID chips, e.g. for such methods in which the coil, without a substrate, is first wound up using a winding machine and provided with the chip in order to then connect the entire unit to the substrate.

Accordingly, protection is also sought for a method characterized in that the wire, prior to it being fed into the wire guide used for laying the wire on a substrate or for winding the wire on a winding plate, is stripped or decoated and/or cleaned and/or tin-plated and/or coated with a conductive adhesive or contacting agent in an area which later forms one tail end of one and a front end of a second coil;

### List of Reference Symbols

- 1: RFID card
- 2: Card substrate, in short also referred to as substrate
- 3: Wire conductor
- 4: Chip
- 5: Front end of the wire conductor
- 6: Tail end of the wire conductor
- 7: First contact surface chip
- 8: Second contact surface chip
- 9: Coil
- 10: Wire laying pin
- 11: Welding die
- 12: Wire gripper
- 13: Starting point of the wire laying cycle
- 14: End point of the wire laying cycle
- 15: Wire line
- 16: Vibrating die (first design)
- 17: Vibrating die (second design)
- 18: Bent tongs of the wire gripper
- 19: Wire guiding runner
- 20: Wire guiding groove
- 21: Central passage of the wire guiding runner
- 22: Panel
- 23: Ultrasonic generator
- 24: Plate
- 25: Wire supply
- 26: Wire guide
- 27: Solder bath or solder jet
- 28: Tube of solder jet
- 29: Solder sphere
- 29': Solder cylinder

- F: Attachment point of the wire conductor
- AR: Arrow illustrating the movement of the wire laying pin and/or the wire gripper
- FL: Free wire length
- A: Starting point of stripping/cleaning/tin-plating on the wire of the coil already laid
- E: End point of stripping/cleaning/tin-plating on the wire of the coil already laid
- A': Starting point of stripping/cleaning/tin-plating on the wire of the coil to be laid next
- E': End point of stripping/cleaning/tin-plating on the wire of the coil to be laid next

## Claims

1. Method for laying a wire conductor (3) on a substrate (2) by means of a wire laying pin (10), which embeds the wire conductor (3) under the influence of ultrasound into the surface of the substrate (2), and for the electrically conductive connection of the wire conductor (3) to a contact surface (7, 8) of a chip (4), which is attached to the substrate, by means of a welding die (11), **characterized in that** the wire laying pin (10), subsequent to an attachment of the wire conductor (3) to the substrate, is lifted off the substrate (2) and then moved into a position starting from which the wire conductor (3) forms a straight wire line (15) extending in the air space above the substrate (4) and extending from the mouth of the wire laying pin (10) to an attachment point (F) at which the wire conductor (3) is attached to the substrate or embedded into the substrate, whereupon the welding die (11) grips the wire in the area between the wire laying pin (10) and the end point (14) of the wire laying cycle, brings it up to the contact surface (7, 8) of the chip (4) associated therewith, and welds it to the contact surface or whereupon a wire gripper (12) grips the wire conductor (3) in the area between the wire laying pin (10) and the attachment point (F), the wire gripper (12) and preferably also the wire laying pin (10) are then moved in such a way that the wire conductor spanned in between them from now on traverses the contact surface (7, 8) of the chip (4) associated therewith, finally the welding die (11) presses the wire conductor spanned in between the wire gripper (12) and the wire laying pin (10) onto the contact surface (7, 8) and welds it to the contact surface.

2. Method preferably according to claim 1, **characterized in that** the wire conductor (3), at the beginning of a wire laying cycle and/or at the end of a wire laying cycle, is held between the wire laying pin (10) and a wire gripper (12) spaced apart therefrom, in such a way that the wire conductor (3) forms a continuously straight wire line (15) extending in the air space above the substrate (2) and extending from the mouth of the wire laying pin (10) to the wire gripper (12), whereupon the welding die (11) grips the wire conductor (3) in the area between the wire laying pin (10) and the wire gripper (12), brings it up to the contact surface (7, 8) of the chip (4) associated therewith, and welds it to the contact surface.

3. Method according to claim 3, **characterized in that** the chip (4) is attached to the substrate (2) only after the wire conductor (3) has been welded to the contact surface (7) of the chip (4).

4. Method according to any one of the preceding claims, **characterized in that** the wire laying pin (10) releases the wire conductor (3), preferably before the welding die (12) impacts the wire conductor (3), in such a way that the welding die (12) is able to draw at least that additional length of the wire conductor (3) from the wire laying pin (10) that is required in order to prevent the wire conductor from breaking due to the influence of the welding die (11).

5. Method according to any one of the preceding claims, **characterized in that**, during the phase in which the welding die (10) brings the wire conductor (3) up to the contact surface (7, 8) or in which the welding die (10) presses the wire conductor (3) onto the contact surface (7, 8), the wire laying pin (10) feeds by means of its active wire feed at least that additional length of the wire conductor (3) that is required in order to prevent the wire conductor (3) from breaking due to the influence of the welding die (11).

6. Method according to claim 1, **characterized in that** the wire laying pin (10) is moved into a position that is so far distant from the attachment point (F) or the wire gripper (12) that the length of the wire conductor (3) forming a line between the mouth of the wire laying pin (10) and the attachment point (F) or the wire gripper (12) is so great that the wire conductor (3) is resilient to such an extent that, by means of the welding die (11), it can be brought up to the contact surface (7, 8) and/or it can be pressed onto the contact surface (7, 8) of the chip (4) associated with it and welded to the contact surface without breaking.

7. Method according to any one of the preceding claims, **characterized in that** the wire laying pin (10) is a passive element and the vibration between the wire laying pin (10) and the substrate (2) required for embedding the wire conductor (3) into the substrate (2) is applied by a vibrating die (16 or 17) which presses through the substrate (2) against the wire laying pin (10) from the side of the substrate (2) facing away from the wire laying pin (10).

8. Method according to any one of the preceding claims, **characterized in that** the wire, prior to it being fed into the wire guide, is stripped or decoated and/or cleaned and/or tin-plated and/or coated with a conductive adhesive or contacting agent in an area which later forms one tail end of one and a front end of a second coil;

9. Method according to any one of the preceding claims, **characterized in that** at least such an amount of wire is always pulled from the wire supply that a free continuous wire is spanned between the mouth section of the wire laying pin and the wire supply with a length which corresponds to at least the wire length required for the production of the next coil, wherein it is calculated in advance which area of the free wire corresponds to the area of the wire in which the wire is later connected to the contact surfaces of a first and a second RFID chip, whereupon this area is pretreated in a manner which later facilitates the electrically conductive connection to the contact surface, preferably by removal of the insulation of the wire in this area and/or tin-plating of the wire in this area, with the wire being fed to the wire laying pin and dispensed via its mouth section after the completion of the pretreatment;

10. Method according to any one of the claims 7 to 9, **characterized in that** a solder jet is used for tin plating in the form of a tube whose mouth is formed, preferably concavely, in such a way that the molten solder, which has preferably been fed against gravity through the inside of the tube, forms a sphere of liquid solder by utilizing the surface tension of the liquid solder, into which sphere the wire to be tin-plated can be immersed or through which it can be pulled and tin-plated in the process.

11. Method according to claim 10, **characterized in that** the solder jet is configured and heated in such a way that the wire can be pulled through the solder jet in the feeding direction and is continuously stripped, cleaned and/or tin-plated in the process.

12. Apparatus for laying a wire conductor (3) on a substrate (2) by means of a wire laying pin (10), which embeds the wire conductor (3) under the influence of ultrasound into the surface of the substrate (2), and for the electrically conductive connection of the wire conductor (3) to a contact surface (7, 8) of a chip (4), which is attached to the substrate, by means of a soldering or welding die (11), **characterized in that** the apparatus is set up for performing a method according to one of the preceding claims.
